# EUROPEAN PATENT APPLICATION

(11) **EP 4 791 181 A1**
(43) Date of publication of application: **12.08.2026**
(21) Application number: 25227425.3
(22) Date of filing: 29.12.2025
(51) Int. Cl.: H10W 90/10, H10W 74/10, H10W 90/00

(54) **POWER DEVICE**

(30) Priority: 11.02.2025 CN 202510149165
(71) Applicant: Delta Electronics, Inc., Taoyuan City 333 (TW)
(72) Inventor: Chen, Jung-Li, 333 Taoyuan City (TW); Tsai, Chang-Chin, 333 Taoyuan City (TW)
(74) Representative: Uexküll & Stolberg

(57) **Abstract**

The power device (1) includes power module (2, 2a, 2b, 2c, 2d, 2e). Each power module (2, 2a, 2b, 2c, 2d, 2e) includes a substrate (3), a chip (4), metal pillars (5), a molding material (6) and current pins. The substrate (3) includes a metal surface (31). The chip (4) is disposed on the metal surface (31). The metal pillars (5) are disposed on the metal surface (31) along a normal direction of the substrate (3). The molding material (6) covers the substrate (3), the chip (4) and the metal pillars (5). The lateral surface (53) of each metal pillar (5) is totally covered by the molding material (6). The top surface (51) of each metal pillar (5) is exposed from a surface of the molding material (6). The first terminal (711) of the current pin (71) of each power module (2, 2a, 2b, 2c, 2d, 2e) is disposed on the top surface (51) of corresponding metal pillar (5) by welding or sintering. The second terminal (712) of corresponding current pin (71) of corresponding power module (2, 2a, 2b, 2c, 2d, 2e) is disposed on the top surface (51) of corresponding metal pillar (5) of another power module (2, 2a, 2b, 2c, 2d, 2e) by welding or sintering.

## Description

### FIELD OF THE INVENTION

The present disclosure relates to a power device, and more particularly to a power device for enhancing functionality.

### BACKGROUND OF THE INVENTION

The power device includes a plurality of power modules. Each power module incudes a lead frame for transmitting signa and current. Normally, the lead frame of the power module is sealed with a molding component. A portion of terminal of the lead frame is exposed from the lateral side of the molding component for connecting with the system. However, the conventional power device is connected with the adjacent system through the lead frame of a single power module. Not every power module can be connected with the adjacent power module. Two different power modules cannot be connected with each other. Consequently, the applicability of the conventional power device is reduced. Moreover, since the lead frame of each power module of the conventional power devices need to be sealed within the molding component, the cost of the lead frames of the power modules repositioned or redesigned is enhanced. Consequently, the practicality of the power device is reduced.

Therefore, there is a need of providing a power device to obviate the drawbacks encountered from the prior arts.

### SUMMARY OF THE INVENTION

The present disclosure provides a power device. The top surface of the metal pillar of the power device of the present disclosure is exposed from the surface of the molding material. The first terminal of at least one first current pin of each power module is disposed on the top surface of the corresponding metal pillar by welding or sintering. The second terminal of the corresponding first current pin of the corresponding power module is disposed on the top surface of another metal pillar of another power module by welding or sintering. The power module of the power device of the present disclosure can be connected with any other power module through the first current pin. Consequently, the applicability of the power device is enhanced. Moreover, the first current pin of the power device can be replaced conveniently. The overall practicality of the power device is improved.

In accordance with an aspect of the present disclosure, a power device is provided. The power device includes a plurality of power modules. Each of the plurality of power modules includes a substrate, a chip, a plurality of metal pillars, a molding material and a plurality of first current pins. The substrate includes a metal surface. The chip is disposed on the metal surface. The plurality of metal pillars are disposed on the metal surface along a normal direction of the substrate. Each of the plurality of metal pillars includes a top surface and a lateral surface. The molding material covers the substrate, the chip and the plurality of metal pillars. The lateral surface of each of the plurality of metal pillars is totally covered by the molding material. The top surface of each of the plurality of metal pillars is exposed from a surface of the molding material. Each of the plurality of first current pins includes a first terminal and a second terminal. The first terminal of at least one of the plurality of first current pins of each of the plurality of power modules is disposed on the top surface of corresponding one of the plurality of metal pillars by welding or sintering. The second terminal of corresponding one of the plurality of first current pins of corresponding one of the plurality of power modules is disposed on the top surface of corresponding one of the plurality of metal pillars of another one of the plurality of power modules by welding or sintering.

The above contents of the present disclosure will become more readily apparent to those ordinarily skilled in the art after reviewing the following detailed description and accompanying drawings, in which:

### BRIEF DESCRIPTION OF THE DRAWINGS

FIG. 1 is a schematic top view illustrating a power device of the present disclosure;
FIG. 2 is a cross-sectional view illustrating a power module according to a first embodiment of the power device of FIG.1;
FIG. 3 is a cross-sectional view illustrating a power module according to a second embodiment of the power device of FIG.1;
FIG. 4 is a schematic top view illustrating a power module according to a third embodiment of the power device of FIG.1;
FIG. 5 is a schematic top view illustrating a power module according to a fourth embodiment of the power device of FIG.1;
FIG. 6 is a schematic top view illustrating a power module according to a fifth embodiment of the power device of FIG.1; and
FIG. 7 is a schematic top view illustrating a power module according to a sixth embodiment of the power device of FIG.1.

### DETAILED DESCRIPTION OF THE PREFERRED EMBODIMENT

The present disclosure will now be described more specifically with reference to the following embodiments. It is to be noted that the following descriptions of preferred embodiments of this disclosure are presented herein for purpose of illustration and description only. It is not intended to be exhaustive or to be limited to the precise form disclosed.

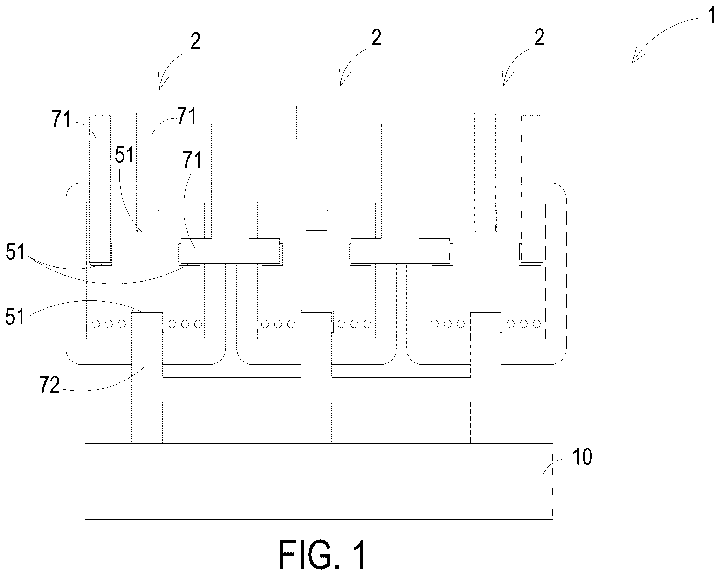

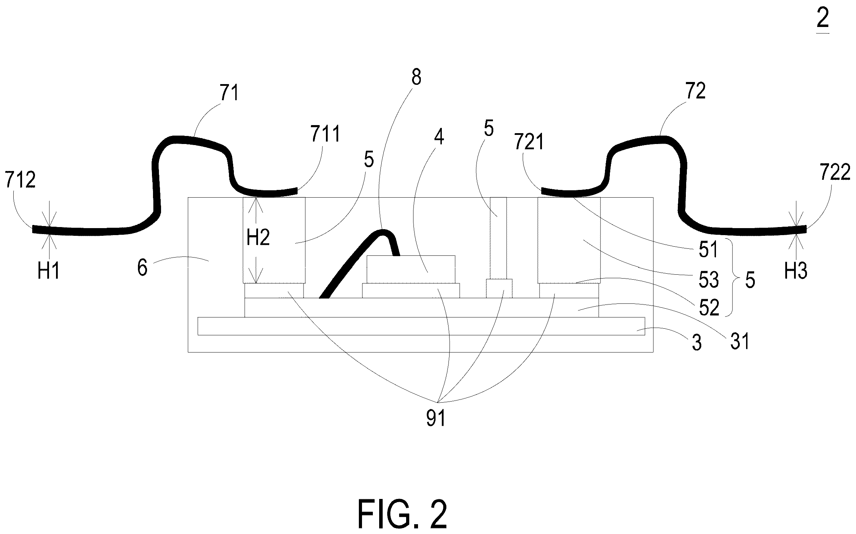

FIG. 1 is a schematic top view illustrating a power device of the present disclosure. FIG. 2 is a cross-sectional view illustrating a power module according to a first embodiment of the power device of FIG.1. As shown in FIGS. 1 and 2, the power device 1 of this embodiment is connected with a system 10 and includes a plurality of power modules 2. As shown in FIG. 1, the power device 1 includes three power modules 2 connected to one another, and the connection relationship will be described below. As shown in FIG. 2, each power module 2 includes a substrate 3, a chip 4, a plurality of metal pillars 5, a molding material 6, three first current pins 71, a second current pin 72 and a metal bonding wire 8. The substrate 3 includes a metal surface 31. The chip 4 is disposed on the metal surface 31 of the substrate 3. As shown in FIG. 2, each metal pillar 5 is served as signal pin or current pin. For example, the two metal pillars 5 located in the left side and the right side of FIG. 2 are served as current pins, and the metal pillar 5 located in the middle of FIG. 2 is served as signal pin. Each metal pillar 5 is arranged on the metal surface 31 of the substrate 3 along the normal direction of the substrate 3. The metal pillars 5 are staggered with the chip 4. Each metal pillar 5 includes a top surface 51, a bottom surface 52 and a lateral surface 53. The top surface 51 and the bottom surface 52 of the metal pillar 5 are opposite to each other. The lateral surface 53 of the metal pillar 5 is disposed between the top surface 51 and the bottom surface 52. The bottom surface 52 of the metal pillar 5 is adjacent to the metal surface 31 of the substrate 3 than the top surface 51. The top surface 51 of the metal pillar 5 is away from the metal surface 31 of the substrate 3 than the bottom surface 52. In this embodiment, as shown in FIG. 1, each power module 2 includes four metal pillars 5. The four metal pillars 5 are served as a DC negative terminal, two DC positive terminals and an AC terminal of the power module 2. For example, the metal pillar 5 located at the top of the power module 2 of FIG. 1 is served as the DC negative terminal of the power module 2, the two metal pillars 5 located on the left side and the right sides of the power module 2 of FIG. 1 are served as the two DC positive terminals of the power module 2, and the metal pillar 5 located at the bottom side of the power module 2 of FIG. 1 is served as the AC terminal of the power module 2.

As shown in FIG. 2, the molding material 6 covers the substrate 3, the chip 4 and the plurality of metal pillars 5. Namely, the substrate 3, the chip 4 and the plurality of metal pillars 5 are embedded within the molding material 6. The substrate 3, the chip 4 and the plurality of metal pillars 5 are totally covered by the molding material 6. The top surface 51 of each metal pillar 5 is exposed from a surface of the molding material 6 away from the substrate 3.

Each first current pin 71 is served as a high-current pin, and includes a first terminal 711 and a second terminal 712. The first terminal 711 of at least one first current pin 71 of each power module 2 is disposed on the top surface 51 of the corresponding metal pillar 5 by welding or sintering. In this embodiment, the first terminal 711 of the first current pin 71 is directly attached to the top surface 51 of the corresponding metal pillar 5 constituted a DC negative terminal or a DC positive terminal by welding or sintering. The second terminal 712 of the corresponding first current pin 71 of the corresponding power module 2 is disposed on the top surface 51 of the metal pillar 5 of another power module 2 by welding or sintering for providing current conduction between two power modules 2. In this embodiment, the first terminal 711 of the first current pin 71 is directly attached to the top surface 51 of the corresponding metal pillar 5 by a solderless welding technique, such as ultrasonic welding or laser welding. The width of the second terminal 712 of the first current pin 71 is equal to the width of the first terminal 711 of the first current pin.

Each second current pin 72 includes a first terminal 721 and a second terminal 722. The first terminal 721 of at least one second current pin 72 of each power module 2 is disposed on the top surface 51 of the corresponding metal pillar 5 by welding or sintering. In this embodiment, the first terminal 721 of the second current pin 72 is directly attached to the top surface 51 of the corresponding metal pillar 5 constituted an AC terminal by welding or sintering. The second terminal 722 of the corresponding second current pin 72 of the corresponding power module 2 is disposed on a system connection terminal of the system 10 by welding or sintering for providing current conduction between two power modules 2. In this embodiment, the first terminal 721 of the second current pin 72 is directly attached to the system connection terminal of the system 10 by a solderless welding technique, such as ultrasonic welding or laser welding. The width of the second terminal 722 of the second current pin 72 is equal to the width of the first terminal 721 of the second current pin 72. The metal bonding wire 8 is connected between a surface of the chip 4 opposite to the substrate 3 and the metal surface 31 of the substrate 3 for providing current conduction between the chip 4 and the substrate 3. In this embodiment, three power modules 2 can be connected in series or in parallel with one another through the connection arrangement of the first current pins 71 and the second current pins 72. Certainly, the three power modules 2 may also be connected in series or in parallel with other power modules through the connection arrangement of the first current pins 71 and the second current pins 72.

From above, the top surface 51 of the metal pillar 5 of the power device 1 of the present disclosure is exposed from the surface of the molding material 6. The first terminal 711 of at least one first current pin 71 of each power module 2 is disposed on the top surface 51 of the corresponding metal pillar 5 by welding or sintering. The second terminal 712 of the corresponding first current pin 71 of the corresponding power module 2 is disposed on the top surface 51 of another metal pillar 5 of another power module 2 by welding or sintering. The conventional power device can only be connected to an adjacent power module. Compared with the conventional power device, the power module 2 of the power device 1 of the present disclosure can be connected with any other power module 2 through the first current pin 71. Consequently, the applicability of the power device 1 is enhanced. Moreover, the first current pin 71 of the power device 1 can be replaced conveniently. The overall practicality of the power device 1 is improved.

Please refer to FIG. 2 again. The power module 2 further includes column solders 91. The column solders 91 are disposed and attached between the bottom surface 52 of the corresponding metal pillar 5 and the metal surface 31 of the substrate 3, and/or the column solders 91 are disposed and attached between the chip 4 and the metal surface 31 of the substrate 3. In this embodiment, the thickness H1 of each first current pin 71 of the power module 2 is less than the thickness H2 of the corresponding metal pillar 5 along the normal direction of the substrate 3. Namely, the thickness H1 of each first current pin 71 is less than the thickness H2 of the corresponding metal pillar 5 connected correspondingly along the normal direction of the substrate 3. Consequently, the first current pin 71 can be welded to the corresponding metal pillar 5 easily. Similarly, the thickness H3 of each second current pin 72 of the power module 2 is less than the thickness H2 of the corresponding metal pillar 5 along the normal direction of the substrate 3. Consequently, the second current pin 72 can be welded to the corresponding metal pillar 5 easily.

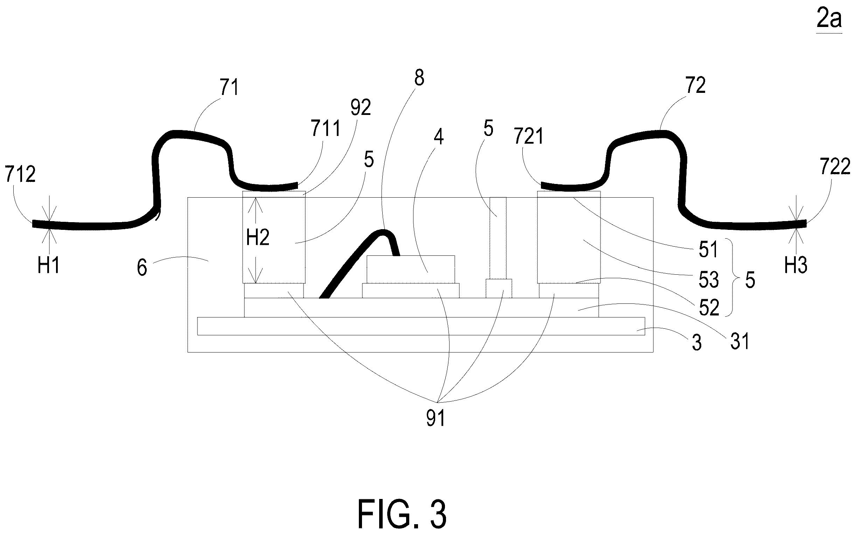

FIG. 3 is a cross-sectional view illustrating a power module according to a second embodiment of the power device of FIG.1. As shown in FIG. 3, compared with the power module 2 of FIG. 2, the power module 2a of this embodiment further includes pin solders 92. The pin solders 92 are disposed and attached between the first terminal 711 of the corresponding first current pin 71 and the top surface 51 of the corresponding metal pillar 5 constituted a DC negative terminal or a DC positive terminal.

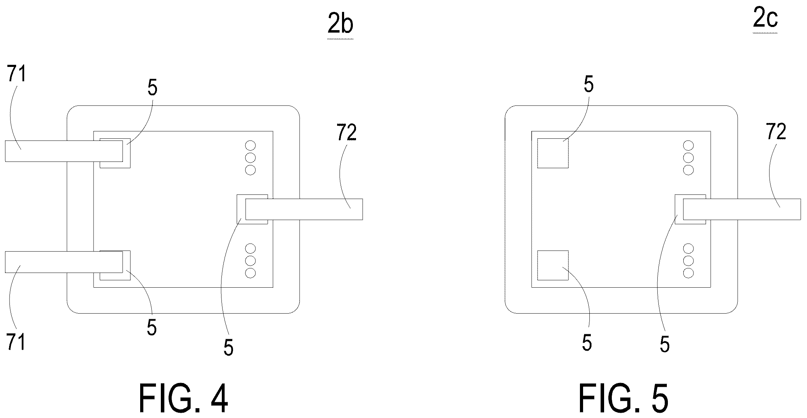

FIG. 4 is a schematic top view illustrating a power module according to a third embodiment of the power device of FIG.1. As shown in FIG. 4, compared with the power module 2 of FIG. 1, the power module 2b of this embodiment only includes three metal pillars 5. The three metal pillars 5 are served as a DC negative terminal, a DC positive terminal and an AC terminal of the power module 2, respectively. For example, the two metal pillars 5 located on the left side of the power module 2 of FIG. 4 are served as the DC negative terminal and DC positive terminal, respectively. The metal pillar 5 located on the right side of the power module 2 of FIG. 4 is served as the AC terminal. Correspondingly, the power module 2b of this embodiment includes only two first current pins 71 and one second current pin 72. The connection relationship is similar to the connection relationship of the first current pin 71 and the second current pin 72 of the first embodiment, and will not be described hereinafter.

In an embodiment, the power module may not include any first current pin but only a single second current pin. FIG. 5 is a schematic top view illustrating a power module according to a fourth embodiment of the power device of FIG.1. As shown in FIG. 5, compared with the power module 2b of FIG. 4, the power module 2c of this embodiment includes only one second current pin 72. The connection relationship is similar to the connection relationship of the second current pin 72 of the first embodiment, and will not be described hereinafter.

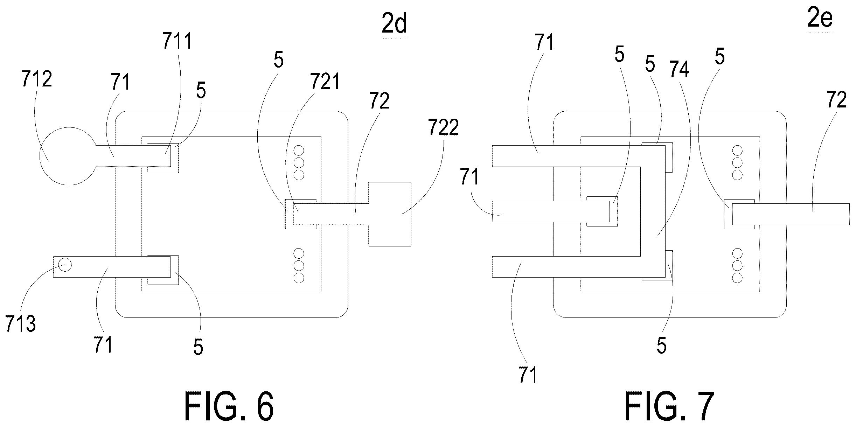

FIG. 6 is a schematic top view illustrating a power module according to a fifth embodiment of the power device of FIG.1. As shown in FIG. 6, in this embodiment, the width of the second terminal 712 of a portion of the first current pins 71 (located at the upper side) is greater than the width of the first terminal 711. The width of the second terminal 72 of the second current pin 72 is greater than the width of the first terminal 721. For example, the shape of the second terminal 712 of the first current pin 71 and/or the second terminal 722 of the second current pin 72 may be rectangular or circular. In this embodiment, the second terminal 712 of a portion of the first current pins 71 (located at the lower side) may has a hole 713 for passing through by screws (not shown). Consequently, the first current pin 71 can be fastened to another metal pillar by screws. Certainly, the second terminal 722 of the second current pin 72 may also include hole, and will not be further described hereinafter.

FIG. 7 is a schematic top view illustrating a power module according to a sixth embodiment of the power device of FIG.1. As shown in FIG. 7, Compared with the power module 2 of FIG. 1, the power module 2e of this embodiment further includes a connecting portion 74. The connecting portion 74 is connected between two corresponding first current pins 71. Namely, the connecting portion 74 is connected between two metal pillars 5 serving as two DC positive terminals of the power module 2, respectively, to provide power transmission between the two metal pillars 5.

As mentioned above, the present disclosure discloses a power device. The top surface of the metal pillar of the power device of the present disclosure is exposed from the surface of the molding material. The first terminal of at least one first current pin of each power module is disposed on the top surface of the corresponding metal pillar by welding or sintering. The second terminal of the corresponding first current pin of the corresponding power module is disposed on the top surface of another metal pillar of another power module by welding or sintering. The power module of the power device of the present disclosure can be connected with any other power module through the first current pin. Consequently, the applicability of the power device is enhanced. Moreover, the first current pin of the power device can be replaced conveniently. The overall practicality of the power device is improved.

## Claims

1. A power device (1), **characterized by** comprising:
a plurality of power modules (2, 2a, 2b, 2c, 2d, 2e), and each of the plurality of power modules (2, 2a, 2b, 2c, 2d, 2e) comprising:
a substrate (3) comprising a metal surface (31);
a chip (4) disposed on the metal surface (31);
a plurality of metal pillars (5) disposed on the metal surface (31) along a normal direction of the substrate (3), and each of the plurality of metal pillars (5) comprising a top surface (51) and a lateral surface (53);
a molding material (6) covering the substrate (3), the chip (4) and the plurality of metal pillars (5), wherein the lateral surface (53) of each of the plurality of metal pillars (5) is totally covered by the molding material (6), and the top surface (51) of each of the plurality of metal pillars (5) is exposed from a surface of the molding material (6); and
a plurality of first current pins (71), wherein each of the plurality of first current pins (71) comprises a first terminal (711) and a second terminal (712);
wherein the first terminal (711) of at least one of the plurality of first current pins (71) of each of the plurality of power modules (2, 2a, 2b, 2c, 2d, 2e) is disposed on the top surface (51) of corresponding one of the plurality of metal pillars (5) by welding or sintering, and the second terminal (712) of corresponding one of the plurality of first current pins (71) of corresponding one of the plurality of power modules (2, 2a, 2b, 2c, 2d, 2e) is disposed on the top surface (51) of corresponding one of the plurality of metal pillars (5) of another one of the plurality of power modules (2, 2a, 2b, 2c, 2d, 2e) by welding or sintering.

2. The power device (1) according to claim 1, wherein each of the plurality of power modules (2a) further comprises a pin solder (92), the pin solder (92) is disposed and attached between the first terminal (711) of the corresponding one of the plurality of first current pins (71) and the top surface (51) of the corresponding one of the plurality of metal pillars (5).

3. The power device (1) according to claim 1, wherein the first terminal (711) of each of the plurality of first current pins (71) of each of the plurality of power modules (2, 2a, 2b, 2c, 2d, 2e) is directly attached to the top surface (51) of the corresponding one of the plurality of metal pillars (5).

4. The power device (1) according to claim 1, wherein each of the plurality of power modules (2, 2a, 2b, 2c, 2d, 2e) further comprises a bottom surface (52), the bottom surface (52) is opposite to the top surface (51), each of the plurality of power modules (2, 2a, 2b, 2c, 2d, 2e) further comprises a column solder (91), the column solder (91) is disposed between the bottom surface (52) of the corresponding one of the plurality of metal pillars (5) and the metal surface (31) of the substrate (3), and/or the column solder (91) is disposed between the chip (4) and the metal surface (31) of the substrate (3).

5. The power device (1) according to claim 1, wherein each of the plurality of power modules (2, 2a, 2b, 2c, 2d, 2e) further comprises a metal bonding wire (8), the metal bonding wire (8) is connected between a surface of the chip (4) opposite to the substrate (3) and the metal surface (31) of the substrate (3).

6. The power device (1) according to claim **1,** wherein a thickness (H1) of each of the plurality of first current pins (71) of each of the plurality of power modules (2, 2a, 2b, 2c, 2d, 2e) is less than a thickness (H2) of the corresponding one of the plurality of metal pillars (5) along the normal direction of the substrate (3).

7. The power device (1) according to claim 1, wherein a width of the second terminal (712) of each of the plurality of first current pins (71) of each of the plurality of power modules (2d) is greater than or equal to a width of the first terminal (711) of the corresponding one of the plurality of first current pins (71).

8. The power device (1) according to claim 1, wherein the second terminal (712) of each of the plurality of first current pins (71) of each of the plurality of power modules (2d) has a hole.

9. The power device (1) according to claim 1, wherein each of the plurality of power modules (2e) further comprises a connecting portion (74), the connecting portion (74) is connected between two corresponding of the plurality of first current pins (71).

10. The power device (1) according to claim 1, wherein each of the plurality of power modules (2, 2a, 2b, 2c, 2d, 2e) further comprises a second current pin (72), the second current pin (72) comprises a first terminal (721) and a second terminal (722), wherein the first terminal (721) of the second current pin (72) is disposed on the top surface (51) of corresponding one of the plurality of metal pillars (5) by welding or sintering, and the second terminal (722) of the second current pin (72) is disposed on a system connection terminal of a system (10) by welding or sintering.
